# EUROPÄISCHE PATENTSCHRIFT

(11) **EP 1 395 100 B1**
(45) Veröffentlichungstag und Bekanntmachung des Hinweises auf die Patenterteilung: **15.06.2011**
(21) Anmeldenummer: 02405740.8
(22) Anmeldetag: 29.08.2002
(51) Int. Cl.: H05K 3/44, H05K 1/02, H05K 3/00

(54) **Verfahren zur Bearbeitung und Herstellung von Leiterplatten sowie Leiterplatte**
Process for treating and manufacturing of circuit boards and such a circuit board
Procédé de traitement et de fabrication de panneaux à circuit ainsi qu'un tel panneau à circuit

(43) Veröffentlichungstag der Anmeldung: 03.03.2004
(73) Patentinhaber: Asetronics AG, 3018 Bern 18 (CH)
(72) Erfinder: Weber, Walter, 3184 Wünnewil (CH); Rappo, Paul, 3186 Düdingen (CH)
(74) Vertreter: Rutz & Partner

(56) Entgegenhaltungen:
- EP-A- 0 561 620
- EP-A- 1 063 873
- EP-A1- 1 190 801
- CH-A- 691 277
- DE-A- 19 650 813
- US-A- 3 882 264
- US-A- 5 220 487
- PATENT ABSTRACTS OF JAPAN vol. 1997, no. 01, 31. Januar 1997 (1997-01-31) -& JP 08 228056 A (DENKI KAGAKU KOGYO KK), 3. September 1996 (1996-09-03)
- 31447: "ELECTRICAL CONNECTION BY DISPLACEMENT OF INTERNAL PLATES" RESEARCH DISCLOSURE, KENNETH MASON PUBLICATIONS, HAMPSHIRE, GB, Nr. 314, 1. Juni 1990 (1990-06-01), Seite 492 XP000132344 ISSN: 0374-4353
- "HEAT TRANSFER IMPROVEMENT FOR THERMAL CARRIER CIRCUIT CARDS" IBM TECHNICAL DISCLOSURE BULLETIN, IBM CORP. NEW YORK, US, Bd. 35, Nr. 2, 1. Juli 1992 (1992-07-01), Seiten 498-499, XP000313373 ISSN: 0018-8689
- PATENT ABSTRACTS OF JAPAN vol. 1996, no. 06, 28. Juni 1996 (1996-06-28) & JP 08 051267 A (SANKYO SEIKI MFG CO LTD), 20. Februar 1996 (1996-02-20)
- DATABASE WPI Week 198826 Derwent Publications Ltd., London, GB; AN 1988-178097 XP002138912 -& JP 63 114197 A (MITSUBISHI DENKI KK), 19. Mai 1988 (1988-05-19)

## Beschreibung

Die Erfindung betrifft ein Verfahren zur Bearbeitung sowie zur Herstellung von mit wenigstens einem Kühlkörper versehenen Leiterplatten sowie eine nach diesem Verfahren hergestellte Leiterplatte nach dem Oberbegriff des Patentanspruchs 1 bzw. 7 und 12.

Moderne elektronische Bauteile wie Mikroprozessoren und Speichereinheiten weisen stark erhöhte Packungsdichten und Arbeitsgeschwindigkeiten auf, die einen erhöhten Energiebedarf zur Folge haben. Dabei muss nicht nur die benötigte elektrische Energie zugeführt, sondern auch die entstehende Wärmeenergie abgeführt werden. Die Kühlung mittels Luftkonvektion erfordert ebenso wie diejenige mittels Kühlflüssigkeiten grosse Wärmeabfuhrstrukturen. Konduktionswärmeabfuhr kann gemäss [1], G. Herrmann, K. Egerer, Handbuch der Leiterplattentechnik, Band 2, Eugen G. Leuze Verlag, Saulgau 1991, Kapitel 16.4, Seite 402 bei Leiterplatten, die auf Kunststoffsubstraten basieren, aufgrund der schlechten Wärmeleitfähigkeit dieser Materialien nur schwerlich bewerkstelligt werden.

Neuere Entwicklungen haben jedoch erfolgversprechende Wege zur Anwendung der Konduktionswärmeabfuhr aufgezeigt.

Aus [2], U.S. Patent 5,953,208 ist eine Lösung bekannt, bei der ein Kühlkörperteil direkt mit dem elektronischen Bauteil verbunden wird, von dem die Wärmeenergie abzuleiten ist.

Aus [3], EP 0 902 609 A1 ist ein Verfahren zur Herstellung einer Leiterplatte bekannt, die mittels einem dauerelastischen Kleber mit einem Kühlkörperteil, vorzugsweise einer Aluminiumplatte verbunden wird. Gemäss [3] sind auch Verfahren bekannt, bei denen eine eloxierte Aluminiumplatte mit der Leiterplatte verschraubt wird.

Sofern das Kühlkörperteil bzw. die Aluminiumplatte vor der Bearbeitung bzw. Strukturierung (siehe [1], Seite 93) der vorzugsweise mit Kupfer kaschierten Platte montiert wird, wird die Aluminiumplatte mit in das z.B. aus Eisen-III-Chlorid bestehende Ätzbad und/oder in ein Galvanobad eingeführt, so dass nebst dem frei liegenden Kupfer auch Teile der Aluminiumplatte weggeätzt werden. Das Ätzbad bzw. das Galvanobad wird somit verunreinigt, was zu Problemen beim weiteren Verlauf des Ätzverfahrens sowie bei der Entsorgung des Ätzmittels führen kann.

In [4], CH-Patent 691 277 wurde daher ein Verfahren zur Herstellung von mit wenigstens einem Kühlkörper versehenen Leiterplatten vorgeschlagen, bei dem eine Isolationsschicht auf der einen Seite mit einer zur späteren Bildung von Leiterbahnen dienenden Metallschicht und auf der anderen Seite mit einem der Ableitung von Wärme dienenden Kühlkörper verbunden wird, der auf den der Isolationsschicht abgewandten Seiten derart dicht abgedeckt wird, so dass er während der Bearbeitung der Metallschicht nicht mit den dafür benötigten Flüssigkeiten in Berührung gelangt, weshalb das mit dem Ätzmittel gefüllte Galvanikbad bei der Bearbeitung der Metallschicht nicht durch Teile des Kühlkörpers verunreinigt wird.

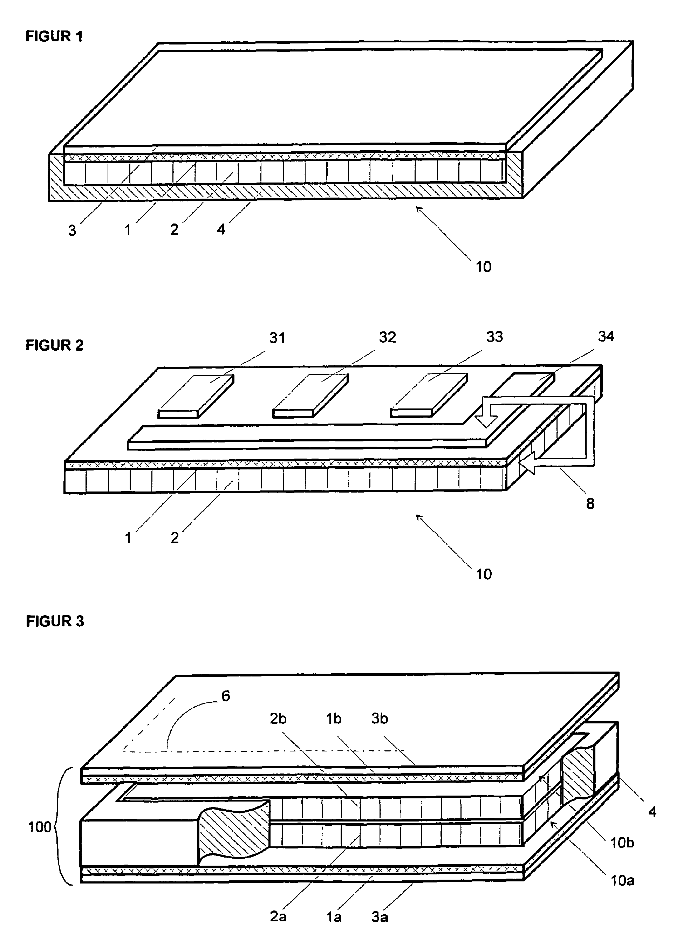

Gemäss [4] lassen sich die Kühlkörper von zwei Leiterplattenlaminaten, die in der Folge gleichzeitig bearbeitet werden, besonders einfach abdecken. Wie nachstehend in Figur 3 gezeigt, werden für diese zweilagige Verarbeitung von Leiterplatten die Kühlkörper 2a, 2b von wenigstens zwei Leiterplattenlaminaten 10a, 10b aneinander gefügt und an den voneinander abgewandten Seiten mittels den Isolationsschichten 1a, 1b, die mit den zur Bildung von Leiterbahnen dienenden Metallschichten 3a, 3b versehen sind, derart abgedeckt, dass ein die Kühlkörper 2a, 2b randseitig umschliessendes Dichtungsmaterial 4 überlappt wird, welches beispielsweise in Form einer Laminatschicht mit eingebunden wird, die zur Aufnahme der Kühlkörper 2a, 2b mit einer entsprechend angepassten Ausnehmung versehen ist. Die Kühlkörper 2a, 2b liegen daher Seite an Seite aneinander und werden vom Dichtungsmaterial 4 randseitig und den dieses überlappenden Isolationsschichten 1a, 1b an den verbleibenden Seiten dicht umschlossen, weshalb die Kühlkörper 2a, 2b bei der Bearbeitung der Metallschichten 3a, 3b nicht mit den Flüssigkeiten des Galvanikbads in Berührung gelangen können.

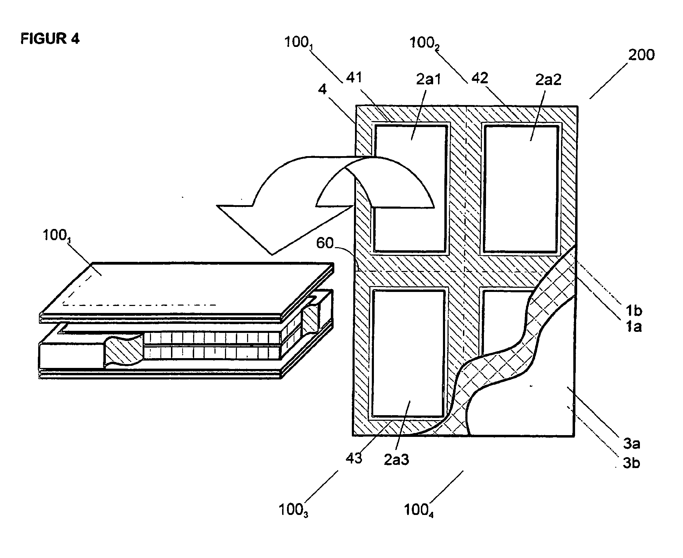

Das in [4] beschriebene Verfahren kann daher auch bei der Verwendung von Fertigungsnutzen 200 bei einem Basismaterialhersteller angewendet werden, bei dem mehrere Fabrikationsnutzen 100₁, 100₂, 100₃, 100₄, wie nachstehend in Figur 4 gezeigt, zu einem Verbund zusammengefasst, gemeinsam verpresst und an den Leiterpattenfabrikanten zur Weiterverarbeitung abgegeben werden.

Die Verwendung grossflächiger Fertigungsnutzen erlaubt die Reduktion von Bearbeitungszeiten und Ausschussmaterialien sowie die bessere Nutzung des hohen Grades an Automation, der in modernen Betrieben üblich ist. Mit zunehmend grösseren Abmessungen der Leiterplatten oder der verwendeten Fertigungsnutzen treten jedoch Verformungen der Laminatschichten störend in Erscheinung, die während des Fertigungsprozesses auftreten können.

Dadurch können einerseits Mängel an den Leiterplatten, gegebenenfalls Mikrorisse in den Leiterbahnen auftreten. Andererseits können Fehler bei der Bearbeitung und beim Transport der Leiterplatten innerhalb der mit kurzen Arbeitszyklen getakteten Produktionsautomaten auftreten.

Aus [5], Marco Leone, On the Coupling of an External Electromagnetic Field to a Printed Circuit Board Trace, IEEE Transactions on EMC, November 1999, pages 418-424, ist ferner bekannt, dass die Einwirkung elektromagnetischer Felder auf elektronische Schaltungen von wesentlicher Bedeutung ist und bereits bei der Designphase der Leiterplatten zu berücksichtigen ist.

Bei mit einem Kühlkörper 2 versehenen Leiterplatten, von denen eine in Figur 2 schematisch gezeigt ist, wurde festgestellt, dass durch die Verbindung des Kühlkörpers 2 mit als Masse dienenden Teilen 34 der strukturierten Metallschicht 3 eine verbesserte Abschirmung gegen elektromagnetische Felder erzielt werden kann. Eine derartige Verbindung 8, wie sie in Figur 2 schematisch dargestellt ist, kann in verschiedener Weise erfolgen. Beispielsweise erfolgt eine Verbindung mittels wenigstens einer Schraube, welche durch die Isolationsschicht 1 hindurchgeführt und in den Kühlkörper 2 derart eingedreht wird, dass der Schraubenkopf einen als Masse dienenden Teil 34 der bearbeiteten Metallschicht 3 kontaktiert. Ferner kann die Leiterplatte 10 mit wenigstens einer Bohrung versehen werden, durch die ein Bolzen hindurchgeführt wird, dessen Enden anschliessend verpresst und dadurch einerseits mit dem Kühlkörper und andererseits mit der Metallschicht 3 oder einem davon verbliebenen Teil elektrisch verbunden werden. Diese Verfahren zur Verbindung des Kühlkörpers mit einem als Masse dienenden Teil der normalerweise bereits bearbeiteten Metallschicht verursachen jedoch einen erheblichen Material- und Arbeitsaufwand. Zudem besteht die Gefahr, dass sich die eingesetzten Verbindungselemente, beispielsweise durch Vibrationen oder Materialdehnungen lösen, wodurch die auf den Leiterplatten vorgesehenen elektronischen Schaltungen Störungen verursachen können, deren Ursachen kaum lokalisierbar sind.

Bei einer mit einem Kühlkörper versehenen Leiterplatte sind daher mehrere Anforderungen zu erfüllen. Einerseits soll eine hohe Spannungsfestigkeit der zwischen der strukturierten Metallschicht und dem Kühlkörper vorgesehenen Isolationsschicht vorhanden sein. Andererseits sollen als Masseanschlüsse dienende Teile der strukturierten Metallschicht, zuverlässig, jedoch mit geringem Aufwand, mit dem Kühlkörper elektrisch verbunden werden.

Einzelne Komponenten einer Schaltungsanordnung, beispielsweise Prozessoren, erzeugen oft eine überdurchschnittlich hohe Verlustwärmeenergie, die nur in ungenügendem Mass an den Kühlkörper übertragen werden kann, weshalb diese Komponenten normalerweise mit zusätzlichem Aufwand, beispielsweise mittels Ventilatoren, punktuell gekühlt werden müssen.

Ferner sollen die der Fertigung der Leiterplatten dienenden Laminate eben ausgerichtet sein, damit sie in den Prozessautomaten problemlos bearbeitet werden können.

Aus [6], EP 1 063 873 A2, ist ein Verfahren bekannt, welches erlaubt, die Metallisierung von Substraten in einem Arbeitsprozess zu strukturieren. Dazu werden die Substrate, deren Metallisierungen zur Strukturierung bereit sind über ein Fixiermittel lösbar und dicht derart miteinander verbunden, dass dazwischen ein abgedichteter Raum resultiert, der mit einem Unterdruck beaufschlagbar ist. Ferner sind fingerartige Profilabschnitte vorgesehen, die in den abgedichteten Raum hinein ragen und eine zusätzliche Unterstützung der Substrate innerhalb der Ringöffnung des Fixierelementes bilden, um zu verhindern, dass durch das Vakuum im abgedichteten Raum zu hohe Spannungen in den Substraten resultieren.

Der vorliegenden Erfindung liegt daher die Aufgabe zugrunde, diese bekannten, der Bearbeitung und Herstellung von mit Kühlkörpern versehenen Leiterplatten dienenden Verfahren zu verbessern.

Insbesondere sollen Verfahren verbessert werden, bei denen ein gegebenenfalls als Fertigungsnutzen dienendes Laminat mit zwei mehrschichtigen zueinander symmetrischen Lagen verarbeitet wird, dessen Kühlkörper mittels eines Dichtungsmaterials dicht abgeschlossen werden.

Weiterhin sollen die beispielsweise mittels eines erfindungsgemässen Verfahrens hergestellten Leiterplatten, die mit einem Kühlkörper versehen sind, mit einfachen Massnahmen wirkungsvoll und zuverlässig gegen die Einwirkungen elektromagnetischer Wellen geschützt werden.

Ferner sollen die beispielsweise mittels eines erfindungsgemässen Verfahrens hergestellten Leiterplatten, die mit einem Kühlkörper versehen sind, zur punktuell verbesserten Ableitung von Verlustwärmeenergie vorgesehen werden.

Weiterhin ist eine nach dem erfindungsgemässen Verfahren hergestellte Leiterplatte, insbesondere eine gegen die Einwirkungen elektromagnetischer Strahlen geschützte Leiterplatte anzugeben.

Die Lösung dieser Aufgabe gelingt mit einem Verfahren gemäss Anspruch 1.

Besonders vorteilhaft beim erfindungsgemässen Verfahren ist, dass mehrere Verbindungen auf einer oder mehreren in einem Fertigungsnutzen enthaltener Leiterplatten kombiniert mit dem Stanzvorgang gleichzeitig gefertigt werden können.

Bei diesem Verfahren, das der Herstellung von wenigstens zwei je mit einem Kühlkörper versehenen Leiterplatten dient, werden zwei als Kühlkörper vorgesehene Metallplatten aufeinander gelegt, randseitig von einem Dichtungsmaterial umschlossen und an deren freiliegenden Seiten mittels einer das Dichtungsmaterial überlappenden Isolationsschicht sowie, aussen daran anliegend, einer der späteren Bildung von Leiterbahnen dienenden Metallschicht abgedeckt.

Erfindungsgemäss wird das resultierende aus zwei mehrschichtigen Lagen bestehende Laminat unter Vakuum derart verpresst und dicht verklebt, dass innerhalb des Laminats ein Vakuum erhalten bleibt, welches das daher durch den äusseren atmosphärischen Druck zusammengepresste Laminat stabilisiert und verhindert, dass darin, beispielsweise durch Temperaturdehnungen verursacht, Wölbungen in den Laminatschichten entstehen.

Die dadurch entstehenden, eben ausgerichteten Laminate lassen sich in den weiteren, normalerweise durch Automaten durchgeführten Prozessschritten problemlos erfassen, transportieren und präzise bearbeiten.

An den Dichtungsrändern, in denen das Dichtungsmaterial von den Isolations- und Metallschichten überlappt wird, können zudem Index- und Fabrikationsbohrungen vorgesehen werden, welche die Durchführung nachfolgender Fabrikationsprozesse erleichtern.

Nach Abschluss des Fertigungsprozesses werden die Leitplatten vereinzelt, wodurch das zuvor erzeugte Vakuum aufgehoben, respektive der atmosphärische Druck auch auf den Innenseiten der Laminatschichten aufgebaut wird.

Eine erfindungsgemäss hergestellte Leiterplatte weist daher einen metallenen Kühlkörper auf, der mittels wenigstens einer Isolationsschicht und gegebenenfalls weiteren Laminatschichten mit wenigstens einer strukturierten Metallschicht verbunden ist, welche die für eine elektronische Schaltung vorgesehenen Leiterbahnen und wenigstens einen Masseanschluss und/oder einen Kühlanschluss bildet, der zur Abschirmung gegen elektromagnetische Wellen bzw. zur raschen Ableitung von Verlustwärmeenergie mit dem Kühlkörper verbunden ist.

Die Erfindung wird nachstehend anhand einer Zeichnung näher erläutert. Dabei zeigt:
- Figur 1: den bekannten Aufbau einer erfindungsgemässen Leiterplatte 10 mit einem Kühlkörper 2, der über eine Isolationsschicht 1 mit einer Metallschicht 3 verbunden ist und der mittels eines Dichtungsmaterials 4 dicht abgeschlossen ist,
- Figur 2: die Leiterplatte 10 von Figur 1, nach der Bearbeitung der Metallschicht 3 und der Entfernung des Dichtungsmaterials 4, versehen mit einer schematisch dargestellten elektrischen Verbindung 8 zwischen dem Kühlkörper und der Metallschicht,
- Figur 3: den bekannten Aufbau eines zweilagigen zur Herstellung von zwei oder n-mal-zwei Leiterplatten dienenden Fabrikationsnutzens 100 mit gegeneinander gerichteten Kühlkörpern 2a; 2b, die von Dichtungsmaterial 4 umschlossen sind,
- Figur 4: eine Seite eines Basismaterialnutzens 200, der vier Fabrikationsnutzen 100₁, ..., 100₄ mit in Ausnehmungen 41, ..., 44 eines Dichtungsmaterials 4 eingeschlossenen Kühlkörpern 2a1, ..., 2a4; 2b1, ..., 2b8 aufweist,
- Figur 5: den Fertigungsnutzen 100 nach Bearbeitung der ersten Metallschicht 3a, 3b und dem Auftrag und der Bearbeitung von zwei weiteren Isolations- und Metallschichten 1a', 1a"; 16', 1b" bzw. 3a', 3a''; 3b', 3b" ' sowie mit der Verbindung der Metallschichten 3, 3a', 3a''; 3, 3b', 3b'' dienenden Microvias 20, 21, 22, und
- Figur 6: den Fertigungsnutzen 100 von Figur 3 mit der Fabrikation dienenden Index- und Fabrikations- bohrungen 1001, ..., 1005, die in neutrale Zonen des später abzutrennenden Randbereichs des Laminats 100 eingefügt sind.

Figur 1 zeigt den bekannten Aufbau einer erfindungsgemässen Leiterplatte 10, die einen zur Ableitung von Wärme dienenden Kühlkörper 2 aufweist, der über eine Isolationsschicht 1 mit einer gegebenenfalls zur späteren Bildung von Leiterbahnen dienenden Metallschicht 3 verbunden ist. Bei der Bearbeitung der Metallschicht 3, die vorzugsweise aus Kupfer besteht, ist die mit der Isolationsschicht 1 verbundene Seite des Kühlkörpers 2 abgedeckt und somit, z.B. beim Eintauchen in ein Ätzbad gegen Korrosion geschützt. Zum Schutz der weiteren Seiten des Kühlkörpers 2 gegen die Einwirkungen des Ätzmittels, sind diese von einem Dichtungsmaterial 4 dicht umschlossen, so dass der Kühlkörper 2 vollständig abgedeckt ist. Somit wird verhindert, dass während des Ätzvorgangs durch vom Kühlkörper 2 abgelöste Teile das Ätzbad verunreinigt wird.

Figur 2 zeigt die Leiterplatte 10 nach der Bearbeitung bzw. Strukturierung der Metallschicht 3 und anschliessender Entfernung des Dichtungsmaterials 4. Dabei sind mehrere durch die Strukturierung gebildete Leiterbahnen 31, 32, 33, 34 gezeigt, die nach einem Verfahren gebildet wurden wie es beispielsweise in [1], Seite 18 und Seite 93 beschrieben ist.

Das in Figur 1 gezeigte Laminat ist daher als Basismaterial für die Fertigung von Leiterplatten besonders gut geeignet. Die vorzugsweise plattenförmigen Kühlkörper 2 aus Aluminium verleihen der Leiterplatte 10 eine hohe Stabilität, so dass dünne Isolationsschichten 1 verwendet werden können. Die Dicke der Isolationsschicht 1 liegt dabei vorzugsweise im Bereich von 1 % - 10 % der Dicke der Kühlkörperplatte 2, die beispielsweise nur wenige Millimeter beträgt.

Die in Figur 1 gezeigte Leiterplatte 10 wird hergestellt, indem auf einer Seite einer Isolationsschicht 1 ein vorzugsweise plattenförmiger Kühlkörper 2 aus Aluminium und auf der anderen Seite eine zur späteren Bildung von Leiterbahnen dienende Metallschicht 3 aus Kupfer angeordnet wird. Die genannten Schichten 1, 2 und 3 werden mittels eines zugeführten Klebstoffs oder mittels der als Klebstoff dienenden Isolationsschicht 1 miteinander verbunden. Die Verbindung der Schichten 1, 2 und 3 erfolgt vorzugsweise gleichzeitig mit der Verbindung des Dichtungsmaterials 4 durch Druck, gegebenenfalls unter gleichzeitiger Wärmezufuhr.

Für die erfindungsgemässen Leiterplatten 10 verwendbare Basismaterialien sind beispielsweise in [1], Kapitel 3 und 4, Seiten 46 - 89 beschrieben. Die Isolationsschicht 1 besteht vorzugsweise aus einem mit Kunstharz, z.B. Epoxyharz, getränkten Glasfasergeflecht, das unter dem Begriff PREPREG bekannt ist (siehe z.B. [1], Seite 53). Da der Kunstharz bei diesem Material nur teilweise auspolymerisiert ist, kann dieses unter Druck, gegebenenfalls zusätzlich unter Wärmezufuhr, verflüssigt werden, so dass die dadurch erzeugte Flüssigkeit in die benachbarten Schichten eindringt und sich mit diesen verbindet oder zumindest daran anhaftet.

Das Dichtungsmaterial 4 besteht vorzugsweise ebenfalls aus einem mit Kunstharz, z.B. Epoxyharz, getränkten Glasfasergeflecht, wie FR4, das im Vergleich zu PREPREG einen erhöhten Polymerisationsgrad aufweist.

Die Isolationsschicht 1 und das Dichtungsmaterial 4 sind in den Abmessungen vorzugsweise derart gewählt, dass sie sich gegenseitig überlappen und daher miteinander verbinden, sobald die Isolationsschicht 1 unter Druck verflüssigt wird.

An den Dichtungsrändern, in denen das Dichtungsmaterial 4 von den Isolations- und Metallschichten 1a, 1b; 3a; 3b überlappt wird, können, wie in Figur 11 gezeigt, zudem Index- und Fabrikationsbohrungen vorgesehen werden, welche die Durchführung nachfolgender Fabrikationsprozesse erleichtern.

Figur 3 zeigt den bekannten Aufbau eines Fertigungsnutzens 100 mit gegeneinander gerichteten Kühlkörpern 2a, 2b, die randseitig durch Dichtungsmaterial 4 umschlossen und an den voneinander abgewandten Seiten über Isolationsschichten 1a, 1b mit Metallschichten 3a, 3b verbunden sind, so dass sie nach dem Verbinden der einzelnen Schichten vollständig abgedeckt sind. Die Isolationsschichten 1a, 1b und die Metallschichten 3a, 3b überlappen das die Kühlkörper 2a, 2b umgebende Dichtungsmaterial 4 derart, dass nach dem Pressen der Schichten eine gute Verbindung zwischen den Isolationsschichten 1a, 1b und den Metallschichten 3a, 3b sowie dem Dichtungsmaterial 4 entsteht.

Der zweilagige Fertigungsnutzen 100 dient beispielsweise zur Herstellung von zwei Leiterplatten 10a, 10b oder n-mal-zwei Leiterplatten 10a₁, ..., 10aₙ bzw. 10b₁, ..., 10bₙ

Die beiden der Bildung von Leiterplatten 10a₁, ..., 10aₙ bzw. 10b₁, ..., 10bₙ dienenden Lagen des Fertigungsnutzens 100 werden somit durch das beidseitig an den Isolationsschichten 1a, 1b anhaftende Dichtungsmaterial 4 zusammen gehalten.

In weiteren Schritten des Fertigungsprozesses, in denen das Laminat 100 bzw. die Leiterplatten 10a₁, ..., 10aₙ bzw. 10b₁, ..., 10bₙ normalerweise mittels schnell getakteten Automaten befördert und bearbeitet werden, sind die Laminatschichten 1a; 1b, 2a; 2b, 3a; 3b meist starken Temperaturänderungen unterworfen, wodurch Wölbungen auftreten können, welche die weitere Bearbeitung, beispielsweise das präzise Erfassen, Bearbeiten und Befördern des Fertigungsnutzens 100 behindern können.

Erfindungsgemäss wird der aus zwei mehrschichtigen Lagen bestehende Fertigungsnutzen 100 daher unter Vakuum derart verpresst und dicht verklebt, dass darin ein Vakuum erhalten bleibt, welches den Fertigungsnutzen 100 stabilisiert und verhindert, dass, beispielsweise durch Temperaturdehnungen verursacht, Wölbungen in den Laminatschichten 1a; 1b, 2a; 2b, 3a; 3b entstehen können. Die Laminatschichten 1a; 1b, 2a; 2b, 3a; 3b werden daher durch den äusseren atmosphärischen Druck zusammengepresst und stabil gehalten. Temperaturdehnungen, die in den Laminatschichten 1a; 1b, 2a; 2b, 3a; 3b, insbesondere in den Kühlkörpern 2a; 2b auftreten können, kompensieren sich zudem durch den symmetrischen Aufbau des Fertigungsnutzens 100.

Der eben ausgerichtete Fertigungsnutzen 100 lässt sich in den weiteren, normalerweise von Automaten durchgeführten

Prozessschritten, beispielsweise mittels den in Figur 11 gezeigten Fabrikations- und Indexbohrungen problemlos erfassen, transportieren und präzise bearbeiten.

Nach Abschluss des Fertigungsprozesses wird das Dichtungsmaterial 4 z.B. mittels Schneiden, Ritzen, Fräsen oder Stanzen entlang der in Figur 3 eingezeichneten Trennlinie 6 vom Fertigungsnutzen 100 abgelöst, wonach die Leiterplatten 10a₁, ..., 10aₙ bzw. 10b₁, ..., 10bₙ unter Aufhebung des Vakuums vereinzelt werden können.

Figur 4 zeigt einen grossflächigen, zweilagigen Basismaterialnutzen 200, in dem vier Fertigungsnutzen 1001, ..., 1004 zusammengefasst sind, von denen der in Figur 3 gezeigte Fertigungsnutzen 100 durch Fräsen oder Stanzen entlang der Trennlinie 60 herausgetrennt und weiterverarbeitet werden kann. Schraffiert dargestellt ist das Dichtungsmaterial 4, welches wie in Figur 3 gezeigt, die Kühlkörper 2 dicht umschliesst. Beide Seiten des Dichtungsmaterials 4 und die nach aussen gewandten Seiten der Kühlkörper 2a1, ..., 2a8 bzw. 2b1, ..., 2b8 sind mit je einer Isolationsschicht 1a bzw. 1b und einer daran anliegenden Metallschicht 3a bzw. 3b abgedeckt.

Erfindungsgemäss wird auch das derart gebildete Laminat des Basismaterialnutzens 200 unter Vakuum derart verpresst und dicht verklebt, dass darin ein Vakuum erhalten bleibt, welches das Laminat stabilisiert. Die Anwendung des erfindungsgemässen Verfahrens erlaubt die Verarbeitung von Basismaterialnutzen und Fertigungsnutzen mit grösseren Abmessungen, ohne dass störende Verformungen störend in Erscheinung treten.

Die erfindungsgemässen Verfahren zur Herstellung und Bearbeitung von mit einem Kühlkörper versehenen Leiterplatten 10 wurden in bevorzugten Ausgestaltungen beschrieben und dargestellt. Anhand der erfindungsgemässen Lehre sind jedoch weitere fachmännische Ausgestaltungen realisierbar. Insbesondere sind beliebige Materialien für den Schichtaufbau der Laminate wählbar. Die Metallschicht 3 ist vorzugsweise mit Gold plaquetiert. Selbstverständlich sind weitere Schichten in das Laminat einfügbar. Ferner sind die Masseverbindungen natürlich auch erstellbar, bevor die Leiteplatten ausgestanzt werden. Weiterhin sind weitere Ausgestaltungen der zur Erstellung der Verbindungen 8 dienenden Werkzeuge 91, 92, 93, 94 wählbar.

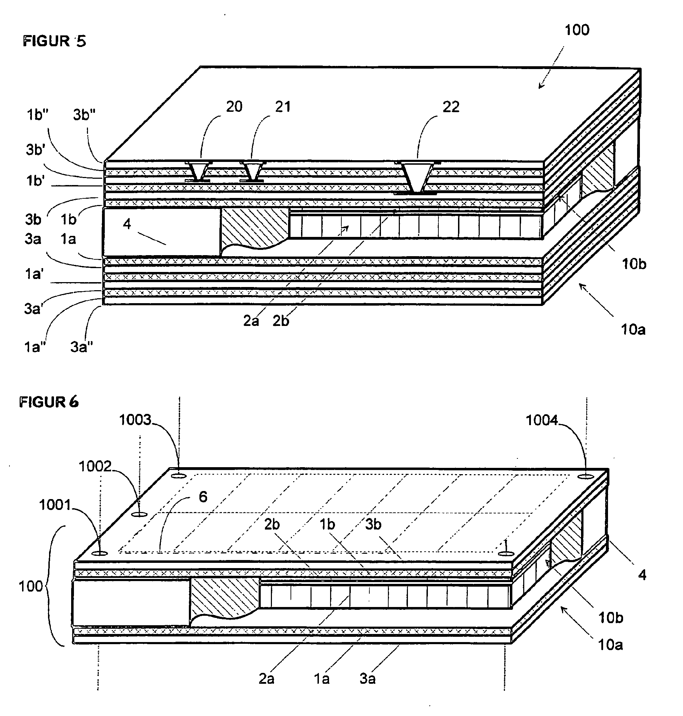

Die erfindungsgemässen Lösungen können ferner unabhängig vom gewählten Schichtaufbau des Laminats angewendet werden. Figur 5 zeigt den Fertigungsnutzen 100 nach Bearbeitung der ersten Metallschicht 3a, 3b und dem Auftrag und der Bearbeitung von zwei weiteren Isolations- und Metallschichten 1a' , 1a"; 1b', 1b" bzw. 3a', 3a'';3b', 3b" sowie mit der Verbindung der Metallschichten 3, 3a', 3a''; 3, 3b', 3b" dienenden, sogenannten Microvias 20, 21, 22. Auch dieser zweilagig mehrschichtige Fertigungsnutzen 100 wird vorzugsweise unter Vakuum verpresst und bedarfsweise mit Verbindungen 8 versehen, welche die äusserste Metallschicht 3" bzw. einen darin vorgesehenen Kühlanschluss oder Masseanschluss mit dem Kühlkörper 2 verbinden.

Figur 6 zeigt den mit Index- und Fabrikationsbohrungen 1001, ..., 1005 versehenen Fertigungsnutzen 100 von Figur 3 mit beispielsweise eingezeichneten Trennlinien 6, die anzeigen, dass der Fertigungsnutzen 100 in jeder der beiden Lagen bis zu vierzehn und mehr Leiterplatten 10a₁, ..., 10a₁₄ bzw. 10b₁, ..., 10b₁₄ umfassen kann.

## Patentansprüche

1. Verfahren zur Herstellung von wenigstens zwei je mit einem Kühlkörper (2a, 2b) versehenen Leiterplatten (10a₁, ..., 10aₙ bzw. 10b₁, ..., 10bₙ), bei dem
a) wenigstens zwei als Kühlkörper (2a, 2b) dienende Metallplatten aufeinander gelegt,
b) randseitig von einem Dichtungsmaterial (4) umschlossen und
c) an deren freiliegenden Seiten mittels einer das Dichtungsmaterial (4) überlappenden Isolationsschicht (1a; 1b) sowie, aussen daran anliegend, einer der späteren Bildung von Leiterbahnen dienenden Metallschicht (3a; 3b) abgedeckt werden, **dadurch gekennzeichnet, dass**
der resultierende aus zwei mehrschichtigen Lagen bestehende Basismaterialnutzen (200) oder Fertigungsnutzen (100) unter Vakuum derart verpresst und dicht verklebt wird, dass ein Vakuum im Laminat erhalten bleibt.

2. Verfahren nach Anspruch 1, **dadurch gekennzeichnet, dass** der Basismaterialnutzen (200) oder der Fertigungsnutzen (100) mittels eines Klebers oder mittels der unter Druck verklebenden Isolationsschichten (1a, 1b) verpresst und verklebt wird.

3. Verfahren nach Anspruch 1 oder 2, **dadurch gekennzeichnet, dass** die Isolationsschichten (1a, 1b) aus einem nur teilweise auspolymerisierten glasfaserverstärkten Polymerwerkstoff wie PREPREG bestehen, der sich unter Druck, gegebenenfalls zusätzlich unter Wärmezufuhr, zumindest teilweise verflüssigt und als Klebstoff dient.

4. Verfahren nach Anspruch 1, 2 oder 3, **dadurch gekennzeichnet, dass** in den Zonen, in denen die Isolationsschichten (1a, 1b) und die Metallschichten (3a, 3b) das Dichtungsmaterial (4) überlappen, Index- und/oder Fasbrikationsbohrungen vorgesehen werden.

5. Verfahren nach einem der Ansprüche 1 bis 4, **dadurch gekennzeichnet, dass** wenigstens die Zonen, in denen die Isolationsschichten (1a, 1b) und die Metallschichten (3a, 3b) das Dichtungsmaterial (4) überlappen, gegebenenfalls mit einem zusätzlichen Anteil der Kühlkörper (2a, 2b), vom bearbeiteten Ferigungsnutzen (100) abgetrennt werden, wodurch die Leiterplatten (10a₁, ..., 10aₙ bzw. 10b₁, ..., 10bₙ) vereinzelt werden können.

6. Verfahren nach einem der Ansprüche 1 bis 5, **dadurch gekennzeichnet, dass** der Fertigungsnutzen (100) mit weiteren Isolations- und Metallschichten (1a', 1a";1b', 1b" bzw. 3a' , 3a"; 3b' , 3b") sowie mit der Verbindung der Metallschichten (3, 3a' , 3a" ; 3, 3b' , 3b'') dienenden Microvias (20, 21, 22) versehen wird.

## Claims

1. Method for the production of at least two circuit boards (10a₁, ..., 10aₙ resp. 10b₁, ..., 10bₙ) each provided with a heat sink (2a, 2b), wherein
a) at least two metal plates serving as heat sink (2a, 2b) are placed one on the other;
b) are enclosed on the side of the edges by a sealing material (4) and
c) are covered at their exposed sides by an insulation layer (1a; 1b) overlapping the sealing material (4) and, abutting said insulation layer (1a; 1b) on the outer side, by a metal layer (3a; 3b) serving for subsequently forming conducting tracks,
**characterised in that**,
the resulting base assembly of circuit boards (200) or manufacturing assembly of circuit boards (100), which consists of two multilayered layers, is pressed and airtight conglutinated in such a manner that a vacuum is maintained within the laminate.

2. Method according to claim 1, **characterised in that** the base assembly of circuit boards (200) or the manufacturing assembly of circuit boards (100) is pressed and conglutinated by means of an adhesive or by means of the insulation layers (1a; 1b) that conglutinate under pressure.

3. Method according to claim 1 or 2, **characterised in that**, the insulation layers (1a; 1b) consist of an only partially polymerized glass-fiber reinforced polymeric material such as PREPREG, which, under pressure, if appropriate additionally under application of heat, is at least partially liquefied and serves as an adhesive.

4. Method according to claim 1, 2 or 3, **characterised in that** index and/or manufacturing bores are provided in zones, in which the insulation layers (1a; 1b) and the metal layers (3a; 3b) overlap the sealing material (4).

5. Method according to one of the claims 1 to 4, **characterised in that** the zones, in which the insulation layers (1a; 1b) and the metal layers (3a; 3b) overlap the sealing material (4), if appropriate together with an additional part of the heat sinks (2a, 2b), are separated from the processed manufacturing assembly of circuit boards (100), by which the circuit boards (10a₁, ..., 10aₙ resp. 10b₁, ..., 10bₙ) can be separated from one another.

6. Method according to one of the claims 1 bis 5, **characterised in that** the manufacturing assembly of circuit boards (100) is provided with further insulation- and metal layers (1a', 1a"; 1b', 1b" resp. 3a', 3a", 3b', 3b") and with microvias (20, 21, 22) serving for connecting the metal layers (3, 3a', 3a"; 3, 3b', 3b'').

## Revendications

1. Procédé pour la fabrication de plaquettes de circuit imprimé (10a₁, ..., 10aₙ resp. 10b₁, ..., 10bₙ), munies chacune d'un corps de refroidissement (2a, 2b), où
a) au moins deux plaquettes métalliques servant de corps de refroidissement (2a, 2b) sont placées superposées,
b) sont entourées en bordure par un matériau d'étanchéité (4) et
c) sur les surfaces libres desquelles, sont recouvertes au moyen d'une des couches d'isolation (1a; 1b) chevauchant le matériau d'étanchéité (4), ainsi que, allongé à l'extérieur d'une des couches d'insolation (1a; 1b), d'une des couches métalliques (3a; 3b), servant à la formation ultérieure de pistes conductrices, **caractérisé en ce que**
la plaque de matériau de base (200) ou plaque de fabrication (100) en résultant se composant de deux couches multicouches étant pressée et collée sous vide de sorte qu'un vide est conservé dans le laminé.

2. Procédé selon la revendication 1, **caractérisé en ce que** la plaque de matériau de base (200) ou plaque de fabrication (100) est pressée et collée au moyen d'un adhésif ou au moyen des couches d'isolation (1a, 1b) collées sous pression.

3. Procédé selon la revendication 1 ou 2, **caractérisé en ce que** les couches d'isolation (1a, 1b) se composent d'un matériau polymère renforcé de fibre de verre que partiellement polymérisé par exemple PREPREG, qui se liquéfie au moins partiellement sous pression et le cas échéant en supplément sous apport de chaleur et sert d'adhésif.

4. Procédé selon la revendication 1, 2 ou 3, **caractérisé en ce que** dans les zones dans lesquelles les couches d'isolation (1a, 1b) et les couches métalliques (3a, 3b) recouvrent le matériau d'étanchéité (4), il est prévu des perçages de fabrication et/ou d'index.

5. Procédé selon l'une des revendications 1 à 4, **caractérisé en ce qu'**au moins les zones, dans lesquelles les couches d'isolation (1a, 1b) et les couches métalliques (3a, 3b) chevauchent le matériau d'étanchéité (4), le cas échéant avec une teneur supplémentaire des corps de refroidissement (2a, 2b), sont séparées de la plaque de fabrication (100) usinée, les plaquettes conductrices (10a₁, ..., 10aₙ resp. 10b₁, ..., 10bₙ) pouvant être séparées.

6. Procédé selon l'une des revendications 1 à 5, **caractérisé en ce que** la plaque de base de circuit imprimé (100) est munie d'autres couches métalliques et isolantes (1a', 1a''; 1b', 1b" resp. 3a', 3a''; 3b', 3b") ainsi que de microvias (20, 21, 22) servant à la liaison des couches métalliques (3, 3a', 3a''; 3, 3b', 3b" ).
